# EUROPEAN PATENT SPECIFICATION

(11) **EP 4 632 800 B1**
(45) Date of publication and mention of the grant of the patent: **21.10.2026**
(21) Application number: 24169465.2
(22) Date of filing: 10.04.2024
(51) Int. Cl.: H10P 50/64, H10P 72/00, H10P 74/00, H10P 74/20

(54) **METHOD FOR CONTROLLING A WET ETCHING PROCESS**
VERFAHREN ZUR STEUERUNG EINES NASSÄTZPROZESSES
PROCÉDÉ DE COMMANDE D'UN PROCÉDÉ DE GRAVURE HUMIDE

(43) Date of publication of application: 15.10.2025
(73) Proprietor: Nexgen Wafer Systems Pte. Ltd., 569880, Singapore (SG)
(72) Inventor: HUBER, Martin, 9500 Villach (AT); IBRAHIM, Hazem, 9020 Klagenfurt (AT); SANCHEZ, Daniel, 9500 Villach (AT)
(74) Representative: Maiwald GmbH

(56) References cited:
- US-A1- 2010 151 597
- US-A1- 2018 294 196

## Description

### TECHNICAL FIELD

The present invention generally relates to the field of wet etching processing of specimens, in particular semiconductor wafers. The present invention specifically relates to a method for controlling a wet etching process, a computer program product, a data processing system, and a system for carrying out a wet etching process.

### BACKGROUND OF THE INVENTION

Wet etching is an etching process that takes off material from a specimen or, in other words, substrate material from a substrate by using a chemical liquid or, in other words, a liquid chemical, which may comprise one or more chemical etchants. The specimen, typically a semiconductor wafer, is immersed in the chemical liquid, or the chemical liquid is dispensed onto the wafer, which etches a wafer surface during the process. For semiconductor wafers as specimens, this process is often being used typically for or within wafer thickness reduction, in particular on a backside of the wafer as opposed to a frontside of the wafer. US 2018/294196 A1 describes a method according to the preamble of claim 1. US 2010/151597 A1 describes a method for smoothing the surface of at least one side of a wafer which is obtained by slicing a semiconductor ingot.

The wet etching may be carried out during the backend-of-the-line (BEOL) stage of the semiconductor manufacturing process. In an exemplary BEOL process for power semiconductor devices employing the wafer, the wet etching may be used for wet chemical surface finishing of the wafers. Typically, tape bonding or using a glass carrier wafer and wafer back grinding are preceding the wet etching. Contact formation, annealing and back side metallization may follow the wet etching during the typical BEOL process of semiconductor manufacturing.

The chemical liquid or, in other words, the wet chemistry is typically altering over lifetime during the wet etching process of the specimens, in particular due to the chemical reaction of the chemical liquid with the specimen material, in effect consuming or rendering less effective or ineffective the etchant(s) inside the chemical liquid. The altering of the wet chemistry over lifetime can change the etching results of the specimens consecutively etched over the lifetime of the wet chemistry, when using the same wet chemistry during the wet etching process.

For example, the surface roughness may be different in the specimens etched with the same wet chemistry and hence, the devices using the specimens, e.g., semiconductor devices, may be different in this regard. The surface roughness is an important parameter in wafers because it plays an important role in backside-metal adhesion, packaging and hence reliability of semiconductor devices. For example, the altering of the wet chemistry may be reflected in an altering of the chemical etch-rate over lifetime of the wet chemistry, possibly resulting in undesired thickness variations on the specimen, e.g., in average or in the uniformity of the specimen, over the lifetime of the wet chemistry.

To ensure that the quality of the etched specimens remains constant during the wet etching process using the same wet chemistry, it is important to reduce the effect of the altering of the wet chemistry over its lifetime. For this purpose, it is known to utilize the concept of an average wet chemistry lifetime, also referred to as a wet chemistry bath lifetime, wherein the wet chemistry is contained as a bath in the broadest sense within a container. After reaching the average wet chemistry lifetime, independent from the actual state of the wet chemistry, an exchange of the wet chemistry may be carried out. Hence, the wet chemistry is, on average, only used so long as the altering of the wet chemistry has limited or acceptable effects on the quality of the etching of the specimen, e.g., by resulting in undesired thickness variations on the specimen, and is exchanged before the altering influences the quality of the specimen in an unaccepted way as defined by the average wet chemistry lifetime.

The average wet chemistry lifetime is based on a statistical approach of a series of test runs of wet etching. This process is not optimal because it is using safety margins, which may be non-optimal in terms of specimen processing time, wet chemistry consumption, and specimen quality. On the one hand, choosing the safety margins too high increases the processing time of the specimens because the wet chemistry needs to be exchanged more frequently and more wet chemistry is consumed, which may have been used longer instead of being wasted if the safety margin was chosen too high. On the other hand, when choosing the safety margin too low, specimens, e.g., of different type, size and/or similar, may experience loss of quality during the wet etching processing with the same wet chemistry, potentially resulting in specimens needing to be scrapped because they are not within target parameters, e.g., a target surface roughness range.

Hence, it would be desirable to perform the wet etching process of specimens as fast as possible, with as little resources, e.g., wet chemistry, as needed, and with constant quality, e.g., with a substantially constant target surface roughness range.

### SUMMARY OF THE INVENTION

The above problem is at least partially solved or alleviated by the subject matters of the independent claims of the present disclosure, wherein further examples are incorporated in the dependent claims. The invention is defined by the independent claims.

According to a first aspect of the present disclosure, there is provided a method for controlling a wet etching process, the wet etching process using a chemical liquid comprising one or more chemical etchants for etching specimens, the method comprising:
- obtaining measurement data indicative of a material removal, a thickness and/or a surface roughness of one or more of the specimens etched by the chemical liquid; and
- obtaining control data for controlling one or more settings of the wet etching process based on the measurement data.

The method of this disclosure provides for controlling the wet etching process by controlling one or more settings of the wet etching process based on a measurement of one or more parameters, namely a material removal, a thickness and/or a surface roughness, of one or more specimens etched by the chemical liquid. In other words, first, a measurement of one or more specimens, etched by the wet etching process using the chemical liquid, is performed and the measurement data thereof is obtained. Second, control data is obtained for controlling one or more settings of the wet etching process for the etching of further specimens following the already etched specimen or specimens, which have been previously measured, by the same wet etching process, with the same container containing the chemical liquid that has been used for etching the previous specimens. Thereby, the method does not rely on potentially inaccurate statistical methods to perform the wet etching process of the specimens as fast as possible, with as little resources as needed, e.g., wet chemistry, eliminating too early exchange thereof, and with constant quality, e.g., with a substantially constant target surface roughness range. Instead, the method uses actual measurement data of one or more parameters, in particular target parameters of the wet etching process relating to a target size of the etched specimens or before and after the etching of the specimens and/or quality parameters of the wet etching process associated with a quality of the etched specimens, the quality in particular relating to a size or dimensional tolerance or accuracy of all etched specimens with respect to one or more of the parameters.

The method of the first aspect may in particular be an at least partially or fully computer implemented method. This means that at least one, multiple or all of the steps of the method may be carried out by a data processing system, which may comprise one or more data processing apparatuses, e.g., computers or computing units, which may be part of a system for performing the wet etching process or, in other words, wet etching processing system. Different steps may be carried out by the same or by different computers. A computer is herein understood as a data processing apparatus, which can carry out some, multiple or all steps as defined by the method. The one or more computers may be configured as or provided inside of one or more sensor units, control units and/or other units of the wet etching processing system or separate therefrom but as part of the wet etching processing system. These sensor units, control units and/or other units may also be configured to carry out other control operations than described by the method according to this disclosure.

The obtaining of the measurement data may be performed by the data processing system, for example. Alternatively, or additionally, the obtaining of the measurement data may be performed by one or more sensor units of the wet etching processing system, which may include one or more cameras, which may send the measurement data to the data processing system. In the additional variant of the aforesaid, the one or more sensor units may provide the measurement data to the data processing system to be obtained by it. Alternatively, or additionally, the method of this disclosure may, in addition to obtaining the measurement data, comprise measurement of the measurement data, e.g., by the one or more sensor units of the wet etching processing system.

The obtaining of the control data may be performed by the data processing system, for example. Alternatively, or additionally, the obtaining of the control data may be performed by one or more control units and/or one more operational units configured to carry out the one or more control settings, the unit(s) being of the wet etching processing system. In the additional variant of the aforesaid, the data processing system may provide the control data to the one or more control units and/or one or more operational units to be obtained by it or them, and to be carried out consequently. For example, the one or more control and/or operational units may be configured for exchanging the chemical liquid at least partially, changing a composition of the chemical liquid, e.g., by adding one or more chemical etchants to the chemical liquid, and/or for controlling the etching duration of specimens. For example, the operational units may be or comprise any of, but not limited to, a dispenser or dispensing unit for dispensing the chemical liquid onto a surface of the specimen, a pump fluidically connected to the dispenser and a container, a feed line into the container of the wet etching processing system, the container containing the chemical liquid, and similar.

Alternatively, or additionally, the method of this disclosure may, in addition to obtaining the control data, comprise carrying out the control data, i.e., the one or more settings to be controlled, e.g., by the one or more control units and/or the one or more operational units of the wet etching processing system. The obtaining of the control data may be a determining of the control data, in particular by the data processing system. As described further below, the obtaining of the control data may also be an updating of the control data, in particular of already obtained or existing control data.

The parameters of the material removal, the thickness and/or the surface roughness of the one or more specimens etched by the chemical liquid may be target parameters of the wet etching process relating to a target size set to be obtained in the etched specimens. The target parameter(s) may have a target defined as a target range, the control of the wet etching process aiming or ensuring to bring the target parameter(s) into the target range for ensuring constant quality of the specimens and avoiding scrap parts.

For example, when the parameter is a material removal, than the measurement relates to a material removal by the wet etching process. The material removal may be an overall material removal measured as mass or weight of the specimen before and after the etching, for example. For example, the material removal may be obtained by measuring the weight of the specimen before and after etching.

The thickness may be a thickness measured at one or multiple points or positions of the specimen, for example. For example, the thickness may be measured by means of the one or more sensor units, e.g., a camera unit, such as a white light interferometry. In particular, the thickness may be a thickness variation or total thickness variation of at least a section or substantially the entire specimen or surface thereof, which may reflect the overall uniformity or non-uniformity of a surface of the specimen, in particular of the backside of a semiconductor wafer.

The surface roughness may be a surface roughness of at least a section or substantially the entire surface of a specimen, in particular of the backside of a semiconductor wafer. For example, the surface roughness may be measured by means of the one or more sensor units, e.g., a profilometer.

Herein, the controlling of the one or more settings means that one or more settings are determined or set, i.e. the lifetime of the wet chemistry or, in other words, chemical liquid. The controlling of the one or more settings means adjusting current or currently set settings, a setting relating to a lifetime for exchanging the chemical liquid, by adjusting it, e.g., reducing or extending the lifetime, such that an exchange of the chemical liquid in the container is triggered earlier or later depending on the measurement data. Further examples of control of settings are given below and the control in the examples of the determination or setting and adjustment as described may mutually apply to these settings.

The specimens may for example be wafers, in particular semiconductor wafers. The semiconductor wafers may be used to fabricate integrated circuits. In particular, the wafer may be etched at its backside opposing its frontside, where any of the sides may be used for power supply of the wafer and forming a power semiconductor device. The wafer may comprise Silicon, in particular crystalline Silicon, or any other semiconductor material such as but not limited to Germanium, Gallium arsenide, Indium phosphide, Silicon carbide, Gallium nitride or Sapphire. The specimen may be of any size and geometry. The specimen may for example be disc-shaped. The specimen may alternatively be referred to as a substrate, in particular a disc-shaped substrate. The specimen may alternatively be any other substrate than a wafer, e.g., a metal substrate or glass substrate.

The wet etching process may be a single specimen etching process, in which single specimens may be consecutively etched by dispensing the chemical liquid onto a specimen surface of the specimen. For example, the chemical liquid may be dispensed, e.g., dropped, sprayed or similar, by a nozzle, spraying system or similar dispensing unit of the wet etching processing system onto the specimen surface of the specimen, in particular a side, more particularly a backside, of a wafer. The specimen may be optionally rotated during the dispensing of the chemical liquid or wet etching process for better distribution of the chemical liquid on its surface. An opposing surface may not be needed or must not be subjected to the chemical liquid, in which case a gas stream or similar may be supplied to or at that side, preventing that the chemical liquid reaches that side, in particular the frontside and/or backside of the wafer. The single specimen etching process may be performed by a type of wet etching processing system, which may be referred to as a single specimen wet etching processing system. Only one specimen at a time may be etched, at least within one processing chamber or device for etching, as opposed to when multiple specimens are etched, e.g., by means of batch etching, in which multiple specimens may be placed into a carrier and dipped into a bath of chemical liquid. However, batch etching or other forms than single specimen etching may alternatively be implemented.

The measurement data is consecutively obtained for specimens etched by the wet etching process and the control data is, in particular consecutively, obtained or updated based on each measurement data. For example, every single consecutive specimen or every few consecutive specimens may be measured for obtaining the measurement data. In particular, a sampling or sampling mode may be used, according to which a predetermined sample number and/or sample order is used for obtaining measurement data for specimens according to the sample number and/or the sample order. The sample number may indicate, for example, the number of samples per chemical liquid, per number of specimens, e.g., 100, and/or similar, to be measured. The sample order may indicate the specimens to be measured within the consecutive specimens, e.g., every few consecutive specimens, such as, for example, every 2, 5 or 10 specimens, or a varying, e.g., fixedly varying, or dynamically adopted, number of every few consecutive specimens. The sampling, in particular the sample number and/or sample order, may be dependent on the type, e.g., material, and/or size of wafer, on the type and/or composition of the chemical liquid being used, on the measurement data from the previously measured etched specimens and/or on the (previously) obtained control data, for example. By obtaining or updating the control data based on each one of these measurement data, the wet etching process may be constantly monitored during the wet etching processing of the specimens. In particular, the wet etching process may be monitored such that when the measurement data indicates a quality change of one or more consecutive specimens, e.g., the etched specimens departing from the target range of one or more of the target parameters or coming closer to thresholds of the target range, the control data may be updated to control the one or more settings, e.g., by adjusting a setting and/or determining or setting a new setting, to counter the quality change, in particular quality decrease, by exchanging the chemical liquid in the container at least partially or substantially fully (meaning that some remainder or residue of the previous chemical liquid may still be contained in the container but the most part of the chemical liquid may be replaced).

Either, at least one of the one or more settings relates to an at least partial exchange of the chemical liquid. The at least partial exchange of the chemical liquid may also be a full or substantially full exchange of the chemical liquid contained in the container of the wet etching processing system (meaning that some remainder or residue of the previous chemical liquid may still be contained in the container but the most part of the chemical liquid may be replaced). The for setting relating to the exchange of the chemical liquid indicates a lifetime after which the chemical liquid is to be replaced at least partially, in particular with the same type and/or composition of chemical liquid. Additionally, for example the setting relating to the exchange of the chemical liquid may indicate an amount or substance, e.g., the one or more chemical etchants, of the chemical liquid to be exchanged. By providing a new or fresh chemical liquid or wet chemistry, e.g., as a bath inside the container, the active chemicals or substances, e.g., the one or more chemical etchants, are once again present and/or able to etch the specimen within the target parameter or parameters to meet the thereby set quality requirements of the specimen.

Additionally to the at least partial exchange of the chemical liquid, for example, at least one of the one or more settings may relate to a change of an etching duration. The etching duration may mean the (total) duration of the etching of the specimen in the wet etching process and may be determined by or correspond or substantially correspond to the dispensing time and/or amount of the chemical liquid to be dispensed per specimen, for example. Hence, for example, by adjusting, determining and/or setting the dispensing time and/or amount of the chemical liquid to be dispensed per specimen, the etching quality may be maintained constant within the target parameter(s). For example, the dispensing time may be increased over the lifetime of the wet chemistry such that an increasingly chemically weaker or less reactive wet chemistry in terms of etching rate may still deliver specimens with the target parameter(s) being in the target range at the costs of increased etching duration and thereby increased processing time per specimen. However, this may be tolerated as a trade-off before exchanging the chemical liquid, for example, and help to maintain the quality control of the etched specimen.

Alternatively to the at least partial exchange of the chemical liquid, at least one of the one or more settings relates to a change of a composition of the chemical liquid. The one or more chemical etchants, other chemical substances, and/or additional etchants (other than the one or more chemical etchants in the chemical liquid) are added to the chemical liquid to change the composition of the chemical liquid. This is referred to as spiking or buffering with the respective chemical substance, e.g., etchant. Thereby, less effective or ineffective chemical etchant, which may already have reacted with the specimen, e.g., oxidized, such as but not limited to for example hydrofluoric acid (HF), may be filled up within the container containing the chemical liquid before triggering a substantially full exchange of the chemical liquid or increasing the etching duration to undesired levels. In addition, a proportion or amount of water in the chemical liquid may be determined.

Additionally, or alternatively to the change of the etching duration, for example, at least one of the one or more settings may relate to a change of distribution of the chemical liquid on the specimen. For example, a dispensing profile of the dispensing of the chemical liquid on a surface of the specimen may be adjusted to change the distribution of the chemical liquid on the specimen. For example, the dispensing profile may comprise a pattern of dispensed chemical liquid per time. Alternatively, or additionally, a dispensing direction, a rotation speed and/or direction of the specimen, or similar may be adjusted to change the distribution of the chemical liquid on the specimen. Based on the measurement data, the change of distribution may thereby for example be used to provide a more uniform thickness and/or surface roughness distribution on the surface of the specimen.

The method may for example further comprise:
- obtaining second measurement data indicative of a composition of the chemical liquid,
wherein the control data is further based on the second measurement data. In particular, the amount of the one or more chemical etchant in the chemical liquid may be indicated by the second measurement data. The second measurement data may be based on, obtained or determined by a measurement unit of the wet etching processing system, e.g., an optical spectrometer. Hence, the measurement data indicative of the material removal, the thickness and/or the surface roughness of one or more of the specimens etched by the chemical liquid may also be referred to herein as first measurement data. By having the second measurement data and basing the control data thereupon, the control data may be obtained such that it takes into consideration the composition of the chemical liquid, e.g., the amounts of different chemical substances, such as chemical etchants and other surfaces, e.g., including chemically reacted or less effective or ineffective amounts of chemical etchant(s), e.g., oxidized etchant(s), inside the chemical liquid. This may be useful because the measurement data can be linked to the composition of the chemical liquid and, for example, if the amount of chemically active or effective, e.g., oxidizing, chemical etchant(s) is low in the chemical liquid, a deviation of one or more of the target parameters from a target range can be attributed to the composition and the control data may accordingly be obtained or updated, e.g., by changing the composition of the chemical liquid by adding one or more chemical etchants.

The control data may be further based on threshold data, the threshold data being indicative of a threshold for the material removal, the thickness and/or the surface roughness of the specimens. The threshold may indicate or provide or be associated with the target or target range for the respective target parameter of material removal, thickness and/or surface roughness. Thereby, it may be ensured that the target parameter(s) may be kept within the desired target range. For example, when one, multiple or all of the target parameter(s) are outside of the threshold, e.g., exceed or are below it (depending on the threshold definition), the control data may be obtained or updated to control the one or more settings. The control data may be dependent on the quantity by which the threshold or thresholds, i.e., the target or target range, is or are exceeded or fallen below by the target parameter(s). For example, the one or more settings, e.g., etching duration, may be controlled in correlation, e.g., proportionally, to the quantity of exceedance or falling below of the threshold(s).

Alternatively, or additionally, the control data may be at least partially or fully obtained as output of a machine learning algorithm, the machine learning algorithm being trained at least with the measurement data and/or the control data from previous wet etching processes. The previous wet etching processes may have used different chemical liquids or wet chemistries, e.g., not necessarily in terms of composition but rather with the same composition but chemically used up in terms of their reactiveness for the etching processing during the previous wet etching processes and exchanged by fresh chemical liquid. Hence, the machine learning algorithm, which may be executed by the data processing system, may have learned or have been trained based on at least the measurement data and/or the control data to obtain or update the control data as output of the machine learning algorithm in an optimized way based on the previous historical data of the previous wet etching processes. For example, in the previous wet etching processes, different and/or same types and/or sizes of specimen may have been used and the machine learning algorithm may have learned the optimal or near-optimal control of the one or more settings of the control data based on the different specimen. Also, or alternatively, the previous wet etching processes may have controlled different settings and/or different quantities in the settings, e.g., etching durations or amounts of etchant added to fill up the chemical liquid container, may have been used and the machine learning algorithm may have learned the optimal or near-optimal settings to be controlled in terms of determining or setting them and/or their quantity, for certain measurement data, e.g., a specific total thickness variation range, such that the machine learning algorithm knows and delivers as output the one or more settings to be controlled in a way, such that they optimally deal with the certain measurement data, e.g., a specific total thickness variation range.

It is noted that the basing of the control data on the threshold data, which may be based on a deterministic approach as opposed to a machine learning approach, does not necessarily exclude the machine learning algorithm approach. To the contrary, both may be used in combination, e.g., by having both obtaining the control data and choosing therefrom, or combining both, or in any other way. Further, other or additional ways of obtaining the control data may be employed, such as neural networks or other artificial intelligence methods, for example.

The method may be configured for controlling two or more wet etching processes, in particular each one using a different chemical liquid, and wherein the method comprises:
- obtaining measurement data indicative of a material removal, a thickness and/or a surface roughness of the one or more etched specimen after each one of the two or more wet etching processes; and
- obtaining control data for controlling one or more settings of each one of the two or more wet etching process based on the measurement data.

By means of two or more wet etching processes, the etching of the specimen may be improved. The two or more wet etching processes are in particular carried out consecutively for each one of the specimens. For example, one of the wet etching processes may be used for preparation of the specimen surface to be etched. For example, for this wet etching process, HF may be used as chemical liquid. Then, or alternatively, one of the wet etching processes may be used for polish etching of the surfaced of the specimen. Here, for example, a different chemical liquid (in terms of its composition), e.g., containing HNO3, HF, H2SO4 and H3PO4, may be used. Then, for example, a wet etching process may be used for rough etching of the surface of the specimen. Here, again, a different chemical liquid may be used, e.g., containing HNO3, HF, H2SO4. Hence, each wet etching process processes the surface of the specimen differently based on the used chemical liquid or wet chemistry composition and can be attributed with the aforesaid intentions, i.e., preparation, polishing, and rough etching. Using the method for controlling each one of the two or more, in particular consecutive, wet etching processes, for each one of the different chemical liquids, allows to optimize the quality of the specimen based on controlling the one or more settings in each one of the two or more wet etching processes based on measurement data for or after each one of the wet etching processes. Hence, one could say that the method is applied for every consecutive wet etching processing with a different or the same chemical liquid composition for the same specimen surface.

According to a second aspect of this disclosure, there is provided a computer program product comprising instructions which, when the program is executed by a computer or data processing apparatus, cause the computer or data processing apparatus to carry out the method according to the first aspect of this disclosure.

The computer program product may be a computer program, in particular as such, meaning a computer program consisting of or comprising a program code to be executed by the computer or data processing apparatus. Alternatively, the computer program product may be a product such as a data storage, in particular a computer-readable data storage medium, on which the computer program may be at least temporarily or permanently stored.

According to a third aspect of this disclosure, there is provided a data processing system configured to carry out the method according to the first aspect of this disclosure.

The data processing system may comprise one or more computers or data processing apparatuses as previously described and, optionally, the computer program product of the second aspect of this disclosure.

According to a fourth aspect of this disclosure, there is provided a system for performing a wet etching process, the system comprising the data processing system of the third aspect of this disclosure, a container for containing the chemical liquid, a measurement system for obtaining the measurement data, and a dispenser fluidically connected to the container for dispensing the chemical liquid onto a specimen surface of the one or more specimen from the container.

As previously mentioned, the measurement system may comprise one or more sensor units, including one or more camera units, for obtaining the first measurement data. Moreover, the measurement system may comprise a measurement unit for obtaining the second measurement data, e.g., in the form of an optical spectrometer. Further, the wet etching processing system may comprise a chamber or device for containing the specimen during the dispensing of the chemical liquid onto the specimen surface. Moreover, a rotation unit may be provided in the wet etching processing system for rotating the specimen during the dispensing of the chemical liquid. Further, the wet etching processing system may comprise a feed line, pump and/or similar fluidically connecting the dispenser with the container. Similarly, a drain line, pump and/or similar may be provided in the wet etching processing system to fluidically connect a drain section of the chamber or device with the container to allow drainage of the chemical liquid used for etching the specimen in the chamber or device therefrom and recirculation to the container.

If two or more different wet etching processes are being used, in particular each one using a different chemical liquid, the wet etching processing system may comprise two or more container for each one of the different chemical liquid. Further, the wet etching processing system may comprise separate chambers or drain sections inside one chamber or device for draining and recirculating each one of the different chemical liquids separately to their respective container. Also, the wet etching processing system may comprise an actuator for moving the specimen between the at least two chambers or drain sections, e.g., which may also be rotatable or rotatably connected to the rotation unit, for example, e.g., in the form of a linearly moveable axis to move the specimen between the two chambers or drain sections.

It is noted that the above aspects, examples and features may be combined with each other irrespective of the aspect involved.

The above and other aspects of the present disclosure will become apparent from and elucidated with reference to the drawings described hereinafter.

### BRIEF DESCRIPTION OF THE DRAWINGS

Exemplary embodiments will be further described with reference to Figures, wherein:
Figure 1 shows a perspective view of a wet etching processing system according to an example.
Figure 2 shows a schematic illustration of the wet etching processing system of Fig. 1 with its components.
Figure 3 shows a perspective view of a processing chamber of the wet etching processing system of Figs. 1 and 2 while etching a wafer.
Figure 4 shows a schematic illustration of a BEOL process of a semiconductor manufacturing process.
Figures 5 and 6 show schematic illustrations of the result of different settings controlled during different etching processes as shown in Fig. 4 in terms of quality of the wafers as herein defined.
Figure 7 shows a schematic illustration of a method for controlling the wet etching processes of Fig. 4 and its result in terms of quality of the wafers as herein defined.

The Figures are schematic only and not true to scale. In principle, identical or like parts, elements and/or steps are provided with identical or like reference numerals in the Figures.

### DETAILED DESCRIPTION OF THE INVENTION

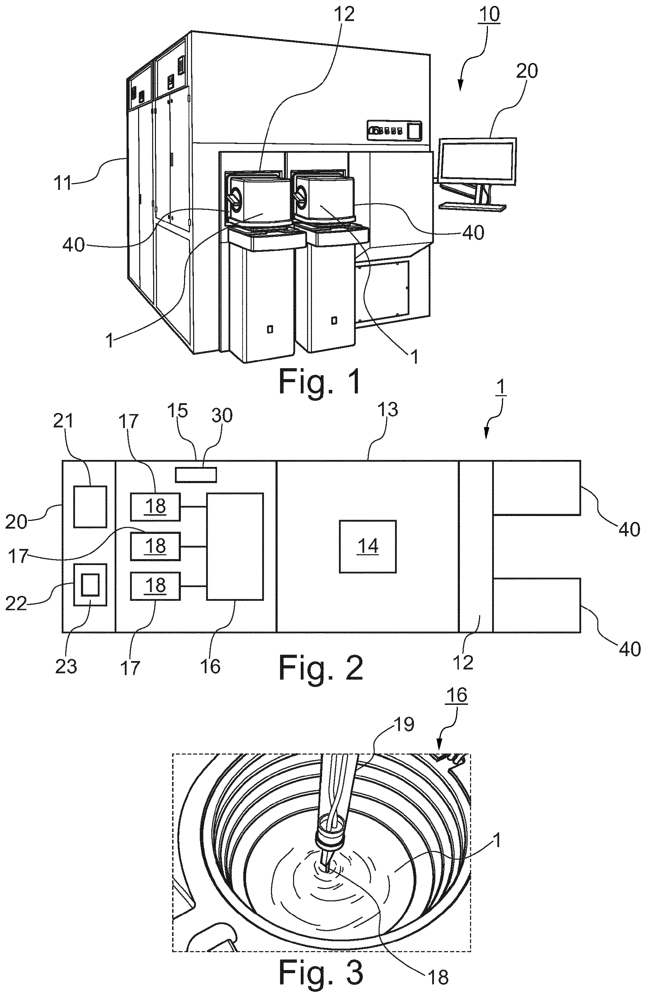

Figure 1 shows a perspective view of a wet etching processing system 10 or, in other words, a system for carrying out a wet etching process 10 according to an example. The wet etching processing system 10 of this example comprises a housing 11 and an obtaining section 12 for obtaining specimens 1, in this exemplary case semiconductor wafers 1 (see Fig. 3).

As shown in Fig. 1, the wafers 1 may be obtained from respective containers 40 containing the wafers 1 (as indicated in Fig. 1). Merely as an example, two containers 40 are shown herein, however, the number of containers 40 may be less or more. For example, one or more of the containers 40 may be containing the wafers 1, which have not yet been processed by the system 10, in particular not have been wet etched, and one or more other containers 40 may be obtaining or receiving the wafers 1 after their processing or wet etching by the system 10.

Additionally, the system 10 comprises a data processing system 20, herein shown exemplary with a monitor and interface for receiving input from a human operator. The data processing system 20 is exemplary shown outside of the housing 11 but may be alternatively positioned also inside the housing 11 and without the monitor and interface, for example.

Figure 2 shows the wet etching processing system 10 in a schematic illustration. Generally, any system, section and similar as shown in system 10 is merely shown herein in position, size and number only schematically and can be located, sized or in number different than shown. The wafers 1 to be etched are received from one or more of the shown containers 40 through the obtaining section 12, e.g., an opening inside the housing 11, and in particular by a handling section 13. The handling section 13 may comprise one or more handling means 14, such as one, two or more robotic arms, for example, for handling the wafers 1. In particular, the handling means 14 may provide the wafers 1 to be etched to a processing section 15, in which a chamber 16 or device may be located for etching the wafers 1. In particular, there may be several processing sections 15 and/or chambers 16 or devices. For example, the wafers 1 may be parallely processed by the respective sections 15 and/or chambers 16. Similarly, the one or more handling means 14 may receive the wafers 1 again once they have been etched and provide them inside of the one or more other containers 40 for receiving the processed wafers 1.

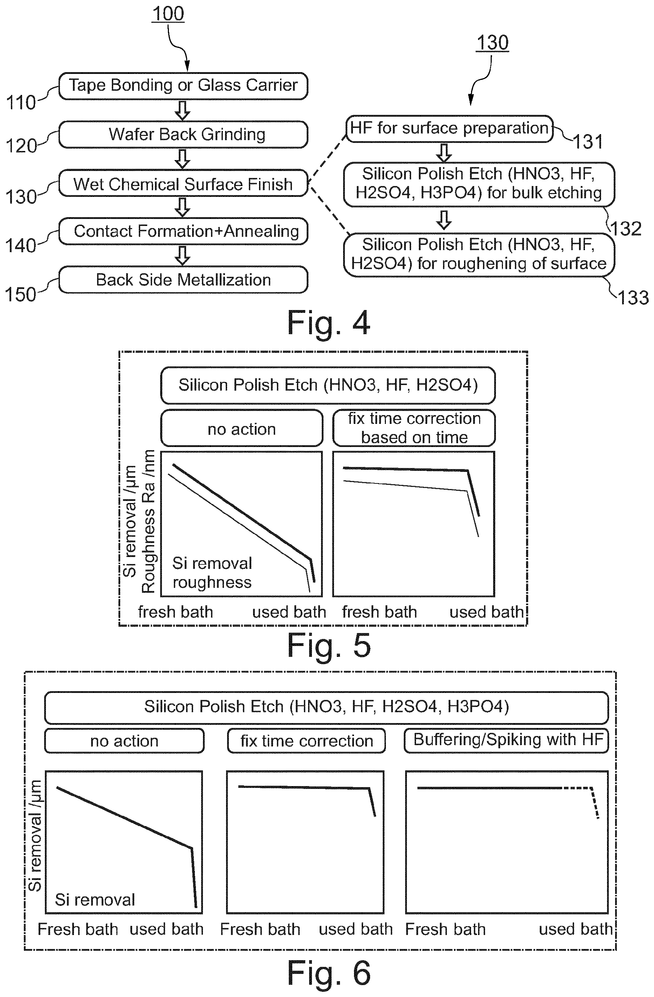

The chamber 16 or device may be supplied with chemical liquid 18 comprising one or more chemical etchants for etching the wafers 1. The chemical liquid 18 may be contained inside one or more containers 17 or, in other words, tanks for containing the chemical liquid 18. The containers 17 may for example be in the range of one to four. The containers 17 may be located inside the system 10, in particular the housing 11, or externally thereof, for example, and connected to the system 10, e.g., via hoses. The chemical liquid 18 may also be herein referred to as a bath or bath of chemical liquid 18. In particular, different chemical liquid compositions may be provided inside of two or, as exemplary shown, three or more containers 17 for different chemical etching processes 131, 132, 133 as exemplary explained hereinafter with reference to Fig. 4.

The wet etching processing system 10, e.g., in the processing section 15, may further comprise one or more measurement systems 30, which may comprise one or more sensor units, including one or more camera units, for obtaining first measurement data indicative of a material removal, a thickness and/or a surface roughness of one or more of the wafers 1 etched by the chemical liquid(s) 18 after one, more or each one of the wet etching processes 131, 132, 133. Optionally, the measurement system 30 may also comprise a measurement unit for obtaining second measurement data indicative of a composition of the chemical liquid(s) 18 inside the container(s) 17, e.g., in the form of an optical spectrometer.

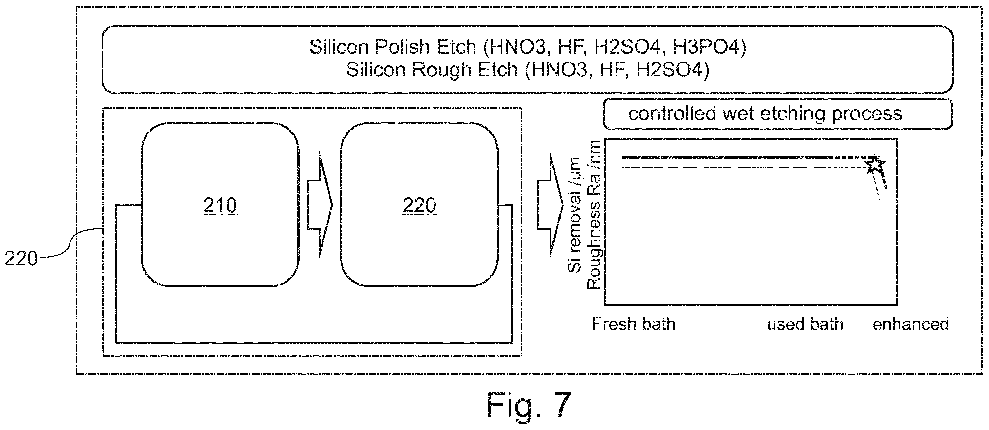

Further, as shown in Fig. 2, the data processing system 20 may comprise a data processing apparatus 21, e.g., in the form of one or more computers or computing units. Moreover, the data processing system 20 may comprise a computer program product 22 in the form of a computer readable storage medium 22, on which a computer program product 23 in the form of a computer program 23 may be stored. When the data processing apparatus 21 carries out the instructions of the computer program 23, the method 200 as shown in Fig. 7 and will be explained hereinafter may be executed.

Figure 3 shows a perspective view of the processing chamber 16 of the wet etching processing system 10. In this example, the wet etching is shown as a single wafer etching process, in which single wafers 1 are consecutively etched by dispensing the chemical liquid 18 onto their surface. However, alternatively, any other type of wet etching processing using a chemical liquid 18, e.g., batch etching, may be used as explained hereinbefore. In this example, the chemical liquid 18 is delivered, e.g., pumped, to a dispenser 19, e.g., in the form of a nozzle, dispensing the chemical liquid 18 onto a surface, in particular frontside, of the wafer 1 provided inside the processing chamber 16. Accordingly, a feed line, pump and/or similar may be provided inside the processing section 15 and connecting the containers 17 with the chamber 16, in particular the dispenser 19 therein. Also, there may be a drain line provided at the containers 17 for draining the chemical liquid 18 therefrom. For example, the wafer 1 may be rotated during the dispensing of the chemical liquid 18 by a rotation unit (not shown), which may, for example, be disposed underneath the wafer 1 and driven by an actuator, e.g., an electric motor. Moreover, as may be seen from Fig. 3, the wafer 1 may be elevated to different levels or drain sections of the processing chamber 16, e.g., for consecutive wet etching with the different chemical liquids 18, e.g., also by an actuator such as an electric motor or the same actuator.

Figure 4 schematically illustrates a backend-of-the-line (BEOL) process 100 of a semiconductor manufacturing process. In the exemplary shown BEOL process for power semiconductor devices employing the wafer 1, the wet etching may be used for wet chemical surface finishing 130 of the wafers 1. Typically, tape bonding or using a glass carrier wafer 110 and wafer back grinding 110 are preceding the wet etching surface finishing 130. Contact formation and annealing 140 and back side metallization 150 may follow the wet etching during the typical BEOL process 100 of semiconductor manufacturing.

Further, as shown for the wet chemical surface finishing 130, for example, three different etching processes 131, 132, 133 may be conducted consecutively, wherein each one of the three different chemical liquids 18 as shown in Fig. 2 may be used, thereby differentiating the wet etching processes 131, 132, 133 from one another. For example, a first wet etching process 131 may be used for preparation of the surface of the wafer 1 to be etched. For example, for this wet etching process, HF may be used as chemical liquid 18. A second wet etching process 132 may be used for polish etching of the surfaced of the wafer 1. Here, for example, a different chemical liquid 18 (in terms of its composition), e.g., containing HNO3, HF, H2SO4 and H3PO4, may be used. A third wet etching process may be used for rough etching of the surface of the wafer 1. Here, again, a different chemical liquid 18 may be used, e.g., containing HNO3, HF, H2SO4. Hence, each wet etching process 131, 132, 133 processes the surface of the wafer 1 differently based on the used chemical liquid 18 or wet chemistry composition and can be attributed with the aforesaid intentions, i.e., surface preparation, polishing, and rough etching.

Figure 5 shows a schematic illustration of the etching result of a setting named fix time correction based on time controlled during the wet etching process 133 as shown in Fig. 4. Specifically, the left graph in Fig. 5 shows that, as the bath of the chemical liquid 18 in the respective container 17 for the silicon rough etch for roughening of the surface gets older through usage over time, the removal of Silicon (Si) in µm and the roughness Ra in nm become less with every wet etched wafer 1, in particular in a linearly decreasing manner. Herein, the roughness Ra is exemplary chosen as an average or arithmetic average of profile height deviations from a mean line. That is because the chemical liquid 18 is altering over lifetime during the wet etching process 133 of the wafers 1, in particular due to the chemical reaction of the chemical liquid 18 with the material of the wafer 1, e.g., Si, in effect consuming or rendering less effective or ineffective the etchant(s) inside the chemical liquid 18. The altering of the wet chemistry over lifetime can change the etching results of the wafers 1 consecutively etched over the lifetime of the wet chemistry, when using the same chemical liquid 18 during the wet etching process 131.

Thus, the bath of chemical liquid 18 may need to be replaced in order to maintain a desired consistency of Si removal and roughness throughout the wafers 1 etched by the same bath of chemical liquid 18. However, an alternative action may be the fix time correction based on time. A control setting of this action may be to change the etching duration, thereby correcting the time based on the usage time of the bath of the chemical liquid 18 so far. For example, the time that the chemical liquid 18 is dispensed on each of the wafers 1, may be increased with increased usage time of the bath, thereby increasing the time the chemical liquid 18 can etch the surface of the wafer 1. As seen in the right graph of Fig. 5, this effectively reduces the decrease in Si removal and roughness over usage time of the bath and thereby allows to control the etching quality of the wafers 1 etched over time using the same bath, i.e., the consistency of the etching results.

Figure 6 shows a schematic illustration of the etching result of a setting of fix time correction, as explained hereinbefore with reference to Fig. 5, and of a setting of buffering or spiking of the chemical liquid 18 with a chemical etchant, herein HF, during the wet etching process 132 as shown in Fig. 4. The left graph in Fig. 6 shows that, as the bath of the chemical liquid 18 in the respective container 17 for the silicon rough etch for roughening of the surface gets older through usage over time, the removal of Si in µm becomes less with every wet etched wafer 1, in particular in a linearly decreasing manner. Thus, the bath of chemical liquid 18 needs to be replaced in order to maintain a desired quality of Si removal and roughness. However, an alternative action may be the fix time correction based on time as shown in the middle graph and explained hereinbefore with reference to Fig. 5. A control setting of this action may be to change the etching duration, thereby correcting the time based on the usage time of the bath of the chemical liquid 18 so far. In particular, the time that the chemical liquid 18 is dispensed on each of the wafers 1, may be increased with increased usage time of the bath, thereby increasing the time the chemical liquid 18 can etch the surface of the wafer 1. As seen in the middle graph of Fig. 6, this effectively reduces the decrease in Si removal and roughness over usage time of the bath and thereby allows to control the quality of the wafers 1 etched over time using the same bath. An alternative control action may be the buffering or spiking with a chemical etchant, herein HF as an example, as shown in the right graph in Fig. 6. The thereon based control setting may be the change of the composition of the chemical liquid 18, e.g., by adding HF as chemical etchant, thereby buffering or spiking the chemical liquid 18 with HF. As shown in the right graph, this may even further enhance the Si removal consistency over the usage time of the bath of the chemical liquid 18.

Figure 7 shows a schematic illustration of a method 200 for controlling any, multiple or all of the wet etching processes 131, 132, 133 of Fig. 4 (on the left of Fig. 7) and its etching result (on the right of Fig. 7). For example, the method 200 is referred to in Fig. 7 to be performed for the wet etching processes 132 and 133, which may be carried out consecutively.

In a first step 210 of method 200, measurement data is obtained, which is indicative of a material removal, e.g., Si in µm, a thickness, e.g., thickness of the wafer in mm or similar, and/or a surface roughness, e.g., Ra in nm, of the wafer 1 etched last by the respective chemical liquid 18 used for that wet etching process 132 or 133. This step may be in particular carried out by the data processing system 20 and/or the measurement system 30. For example, the measurement system 30 may obtain the measurement data through measurement and forward it to the data processing system 20, where it is thereby obtained and may be further processed, in particular for the second step 220, which may follow the first step 210.

In the second step 220, based on the measurement data, control data for controlling one or more settings of the respective wet etching process 132, 133, after which the measurement data has been obtained for the thereafter etched wafer 1, is obtained, in particular determined, by the data processing system 20. For example, the one or more settings may be the change of the etching duration, e.g., fixe time correction as explained hereinbefore, the change of composition of the chemical liquid 18, e.g., buffering or spiking with HF as explained hereinbefore, and/or an at least partial or full exchange of the chemical liquid 18, i.e., changing a part or entirety of the bath of chemical liquid 18 inside the container 17 for the respective wet etching process 132, 133.

In particular, the method 200 may be performed twice, once for wafers 1 after the wet etching process 132 and once for wafers 1 after the wet etching process 133, thereby obtaining control data for controlling one or more settings of each one of the wet etching processes 132, 133. Thereby, after each wet etching process 132, 133, the settings thereof may be controlled such that the result is optimized as seen in the right part of Fig. 7. There, it is shown that by controlling the wet etching processes 132, 133, the Si removal and Roughness may be kept constant or substantially constant for a very long period of bath usage and this quality control may even be enhanced, in particular by using a mix of the aforementioned settings, e.g., by first changing the etching duration, afterwards changing the composition of the chemical liquid 18 and finally changing the chemical liquid 18 or,. In other words, bath, as marked by the star in the graph.

Further, as shown in Fig. 7, the method steps 210 and 220 may be repeated, for example for each or every few wafers 1 processed by the wet etching process 132 and/or the wet etching process 133, thereby continuously monitoring the bath or chemical liquid 18 by means of the measurement data of the wafers 1 and updating the control data when necessary or beneficial.

While the invention has been illustrated and described in detail in the drawings and foregoing description, such illustration and description are to be considered illustrative or exemplary and not restrictive; the invention is not limited to the disclosed embodiments, only limited by the appended claims. Other variations to the disclosed embodiments can be understood and effected by those skilled in the art and practicing the claimed invention, from a study of the drawings, the disclosure, and the claims.

As used herein, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Further, as used herein, the phrase "at least one" or similar, e.g., "one or more of", in reference to a list of one or more entities should be understood to mean at least one entity selected from any one or more of the entities in the list of entities, but not necessarily including at least one of each and every entity specifically listed within the list of entities and not excluding any combinations of entities in the list of entities. This definition also allows that such entities may optionally be present other than the entities specifically identified within the list of entities to which the phrase "at least one" or similar refers, whether related or unrelated to those entities specifically identified. Thus, as a non-limiting example, "at least one of A and B" (or, equivalently, "at least one of A or B" or, equivalently "at least one of A and/or B" or, equivalently "one or more of A and B", "one or more of A or B", or "one or more of A and/or B") may refer, in one example, to at least one, optionally including more than one, A, with no B present (and optionally including entities other than B); in another example, to at least one, optionally including more than one, B, with no A present (and optionally including entities other than A); in yet another example, to at least one, optionally including more than one, A, and at least one, optionally including more than one, B (and optionally including other entities). In other words, the phrases "at least one," "one or more," and "and/or" are open-ended expressions that are both conjunctive and disjunctive in operation. For example, each of the expressions "at least one of A, B, and C," "at least one of A, B, or C," "one or more of A, B, and C," "one or more of A, B, or C," and "A, B, and/or C" may mean A alone, B alone, C alone, A and B together, A and C together, B and C together, A, B, and C together, and optionally any of the above in combination with at least one other entity.

As used herein, the phrase "being indicative of" may for example mean "reflecting" and/or "comprising". Accordingly, an entity, element and/or step referred to herein as "being indicative of [...]" can be synonymously or interchangeably used herein with one, two or all of said entity, element and/or step "comprising [...]" and said entity, element and/or step "reflecting [...]".

Further, as used herein, phrases such as "based on", "related" or "relating", "associated" and similar are not to be seen exclusively in terms of the entities, elements and/or steps to which they are referring, unless otherwise stated. Instead, these phrases are to be understood inclusively, unless otherwise stated, in that, for example, an entity, element or step referring by any of these phrases or similar, e.g., being "based on", an or another entity, element or step, does not exclude that the respective entity, element or step may be further or also "based on" any other entity, element or step than the one to which it refers.

The designation of methods and steps as first, second, etc. as provided herein is merely intended to make the methods and their steps referenceable and distinguishable from one another. By no means does the designation of methods and steps constitute a limitation. For example, when this disclosure describes a third step of a method, a first or second step of the method do not need to be present yet alone be performed before the third step unless they are explicitly referred to as being required per se or before the third step. Moreover, the presentation of methods or steps in a certain order is merely intended to facilitate one example of this disclosure and by no means constitutes a limitation. Generally, unless no explicitly required order is being mentioned, the methods and steps may be carried out in any feasible order. Specifically, the terms first, second, third or (a), (b), (c) and the like in the description and in the claims are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

In the context of the present invention any numerical value indicated is typically associated with an interval of accuracy that the person skilled in the art will understand to still ensure the technical effect of the feature in question. As used herein, the deviation from the indicated numerical value is in the range of ± 10%, and preferably of ± 5%. The aforementioned deviation from the indicated numerical interval of ± 10%, and preferably of ± 5% is also indicated by the terms "about" and "approximately" used herein with respect to a numerical value.

Any reference signs in the claims should not be construed as limiting the scope.

## Claims

1. A method (200) for controlling a wet etching process (131, 132, 133), the wet etching process (131, 132, 133) using a chemical liquid (18) comprising one or more chemical etchants for etching specimens (1), the method (200) comprising:
- obtaining measurement data indicative of a material removal, a thickness and/or a surface roughness of one or more of the specimens (1) etched by the chemical liquid (18); and
- obtaining control data for controlling one or more settings of the wet etching process (131, 132, 133) based on the measurement data,
wherein the measurement data is consecutively obtained for specimens (1) etched by the wet etching process (131, 132, 133) and the control data is obtained or updated based on each measurement data;
**characterised in that** the same container (17) containing the chemical liquid (18) that has been used for etching the previous specimens (1) is used for the controlled wet etching process (131, 132, 133);
wherein the one or more settings are controlled by adjusting the current settings relating to a lifetime for exchanging the chemical liquid (18) by adjusting it such that an at least partial exchange and/or change of composition of the chemical liquid (18) in the container (17) is triggered depending on the measurement data; and
wherein:
(a) at least one of the one or more settings relates to a full or substantially full exchange of the chemical liquid (18) in the container (17) and indicates a lifetime after which the chemical liquid (18) in the container (17) is to be replaced;
(b) at least one of the one or more settings relates to a partial exchange of the chemical liquid (18) in the container (17) indicating an amount and a substance of the chemical liquid (18) to be exchanged in the container (17); and/or
(c) at least one of the one or more settings relates to a change of a composition of the chemical liquid (18) indicating one or more chemical etchants, other chemical substances, and/or additional etchants to be added to the chemical liquid to change the composition of the chemical liquid for spiking or buffering the chemical liquid (18) in the container (17).

2. The method (200) of claim 1, wherein the specimens (1) are wafers (1).

3. The method (200) of claim 1 or 2, wherein the wet etching process (131, 132, 133) is a single specimen etching process, in which single specimens (1) are consecutively etched by dispensing the chemical liquid (18) onto a specimen surface of the specimen (1).

4. The method (200) of any one of the previous claims, wherein at least one of the one or more settings relates to a change of an etching duration.

5. The method (200) of any one of the previous claims, wherein at least one of the one or more settings relates to a change of distribution of the chemical liquid on the specimen (1).

6. The method (200) of any one of the previous claims, wherein the method (200) comprises:
- obtaining second measurement data indicative of a composition of the chemical liquid (18), wherein the control data is further based on the second measurement data.

7. The method (200) of any one of the previous claims, wherein the control data is further based on threshold data, the threshold data being indicative of a threshold for the material removal, the thickness and/or the surface roughness of the specimens (1).

8. The method (200) of any one of the previous claims, wherein the control data is at least partially obtained as output of a machine learning algorithm, the machine learning algorithm being trained at least with the measurement data and/or the control data from previous wet etching processes (131, 132, 133).

9. The method (200) of any one of the previous claims, wherein the method (200) is configured for controlling two or more wet etching processes (131, 132, 133), wherein the method (200) comprises:
- obtaining measurement data indicative of a material removal, a thickness and/or a surface roughness of the one or more etched specimen (1) after each one of the two or more wet etching processes (131, 132, 133); and
- obtaining control data for controlling one or more settings of each one of the two or more wet etching process (131, 132, 133) based on the measurement data.

10. A computer program product (22, 23), which, when executed by a data processing apparatus (21), instructs the data processing apparatus (21) to carry out the method (200) according to any one of the previous claims.

11. A data processing system (20) configured to carry out the method (100) according to any one of claims 1 to 9.

12. A system (10) for carrying out a wet etching process (131, 132, 133), the system (10) comprising the data processing system (20) of claim 11, a container (17) for containing the chemical liquid (18), a measurement system (30) for obtaining the measurement data, and a dispenser (19) fluidically connected to the container (17) for dispensing the chemical liquid (18) onto a specimen surface of the one or more specimen (1) from the container (18).

## Patentansprüche

1. Verfahren (200) zur Steuerung eines Nassätzprozesses (131, 132, 133), wobei der Nassätzprozess (131, 132, 133) eine chemische Flüssigkeit (18) verwendet, die ein oder mehrere chemische Ätzmittel zum Ätzen von Proben (1) umfasst, wobei das Verfahren (200) umfasst:
- Erfassen von Messdaten, die Aufschluss über einen Materialabtrag, eine Dicke und/oder eine Oberflächenrauheit einer oder mehrerer der durch die chemische Flüssigkeit (18) geätzten Proben (1) geben; und
- Erfassen von Steuerdaten zur Steuerung einer oder mehrerer Einstellungen des Nassätzprozesses (131, 132, 133) auf der Grundlage der Messdaten,
wobei die Messdaten nacheinander für Proben (1) erfasst werden, die durch den Nassätzprozess (131, 132, 133) geätzt wurden, und die Steuerdaten auf der Grundlage der jeweiligen Messdaten erfasst oder aktualisiert werden;
**dadurch gekennzeichnet, dass** derselbe Behälter (17), der die chemische Flüssigkeit (18) enthält, die zum Ätzen der vorherigen Proben (1) verwendet wurde, für den gesteuerten Nassätzprozess (131, 132, 133) verwendet wird;
wobei die eine oder mehreren Einstellungen durch Anpassen der aktuellen Einstellungen bezüglich einer Lebensdauer für den Austausch der chemischen Flüssigkeit (18) gesteuert werden, indem diese so angepasst werden, dass in Abhängigkeit von den Messdaten ein zumindest teilweiser Austausch und/oder eine Änderung der Zusammensetzung der chemischen Flüssigkeit (18) im Behälter (17) ausgelöst wird; und
wobei:
(a) sich mindestens eine der einen oder mehreren Einstellungen auf einen vollständigen oder im Wesentlichen vollständigen Austausch der chemischen Flüssigkeit (18) im Behälter (17) bezieht und eine Lebensdauer angibt, nach deren Ablauf die chemische Flüssigkeit (18) im Behälter (17) ausgetauscht werden soll;
(b) sich mindestens eine der einen oder mehreren Einstellungen auf einen teilweisen Austausch der chemischen Flüssigkeit (18) im Behälter (17) bezieht und eine Menge sowie eine Substanz der im Behälter (17) auszutauschenden chemischen Flüssigkeit (18) angibt; und/oder
(c) sich mindestens eine der einen oder mehreren Einstellungen auf eine Änderung der Zusammensetzung der chemischen Flüssigkeit (18) bezieht, wobei ein oder mehrere chemische Ätzmittel, andere chemische Substanzen und/oder zusätzliche Ätzmittel angegeben werden, die der chemischen Flüssigkeit beigemischt werden sollen, um die Zusammensetzung der chemischen Flüssigkeit zu ändern, um die chemische Flüssigkeit (18) im Behälter (17) anzureichern oder zu puffern.

2. Verfahren (200) nach Anspruch 1, wobei die Proben (1) Wafer (1) sind.

3. Verfahren (200) nach Anspruch 1 oder 2, wobei der Nassätzprozess (131, 132, 133) ein Einzelproben-Ätzprozess ist, bei dem einzelne Proben (1) nacheinander geätzt werden, indem die chemische Flüssigkeit (18) auf eine Probenoberfläche der Probe (1) dosiert wird.

4. Verfahren (200) nach einem der vorstehenden Ansprüche, wobei sich mindestens eine der einen oder mehreren Einstellungen auf eine Änderung der Ätzdauer bezieht.

5. Verfahren (200) nach einem der vorstehenden Ansprüche, wobei sich mindestens eine der einen oder mehreren Einstellungen auf eine Änderung der Verteilung der chemischen Flüssigkeit auf der Probe (1) bezieht.

6. Verfahren (200) nach einem der vorstehenden Ansprüche, wobei das Verfahren (200) umfasst:
- Erfassen zweiter Messdaten, die Aufschluss über die Zusammensetzung der chemischen Flüssigkeit (18) geben,
wobei die Steuerdaten ferner auf den zweiten Messdaten basieren.

7. Verfahren (200) nach einem der vorstehenden Ansprüche, wobei die Steuerdaten ferner auf Schwellenwertdaten basieren, wobei die Schwellenwertdaten einen Schwellenwert für den Materialabtrag, die Dicke und/oder die Oberflächenrauheit der Proben (1) angeben.

8. Verfahren (200) nach einem der vorstehenden Ansprüche, wobei die Steuerdaten zumindest teilweise als Ausgabe eines Algorithmus des maschinellen Lernens erfasst werden, wobei der Algorithmus des maschinellen Lernens zumindest mit den Messdaten und/oder den Steuerdaten aus früheren Nassätzprozessen (131, 132, 133) trainiert wurde.

9. Verfahren (200) nach einem der vorstehenden Ansprüche, wobei das Verfahren (200) zur Steuerung von zwei oder mehr Nassätzprozessen (131, 132, 133) ausgelegt ist, wobei das Verfahren (200) umfasst:
- Erfassen von Messdaten, die Aufschluss über einen Materialabtrag, eine Dicke und/oder eine Oberflächenrauheit der einen oder mehreren geätzten Proben (1) nach jedem der zwei oder mehr Nassätzprozesse (131, 132, 133) geben; und
- Erfassen von Steuerdaten zur Steuerung einer oder mehrerer Einstellungen jedes der zwei oder mehr Nassätzprozesse (131, 132, 133) auf der Grundlage der Messdaten.

10. Computerprogrammprodukt (22, 23), das, wenn es von einer Datenverarbeitungsvorrichtung (21) ausgeführt wird, die Datenverarbeitungsvorrichtung (21) anweist, das Verfahren (200) gemäß einem der vorstehenden Ansprüche durchzuführen.

11. Datenverarbeitungssystem (20), das so konfiguriert ist, dass es das Verfahren (100) gemäß einem der Ansprüche 1 bis 9 ausführt.

12. System (10) zur Durchführung eines Nassätzprozesses (131, 132, 133), wobei das System (10) das Datenverarbeitungssystem (20) nach Anspruch 11, einen Behälter (17) zur Aufnahme der chemischen Flüssigkeit (18), ein Messsystem (30) zum Erfassen der Messdaten und eine Dosiervorrichtung (19), die fluidisch mit dem Behälter (17) verbunden ist, um die chemische Flüssigkeit (18) aus dem Behälter (18) auf eine Probenoberfläche der einen oder mehreren Proben (1) zu dosieren, umfasst.

## Revendications

1. Procédé (200) de contrôle d'un processus de gravure humide (131, 132, 133), le processus de gravure humide (131, 132, 133) utilisant un liquide chimique (18) comprenant un ou plusieurs agents de gravure chimiques pour graver des échantillons (1), le procédé (200) comprenant :
- l'obtention de données de mesure indicatives d'un enlèvement de matière, d'une épaisseur et/ou d'une rugosité de surface d'un ou plusieurs des échantillons (1) gravés par le liquide chimique (18) ; et
- l'obtention de données de contrôle destinées à contrôler un ou plusieurs réglages du processus de gravure humide (131, 132, 133) sur la base des données de mesure,
dans lequel les données de mesure sont obtenues consécutivement pour des échantillons (1) gravés par le processus de gravure humide (131, 132, 133) et les données de contrôle sont obtenues ou mises à jour sur la base de chacune des données de mesure ;
**caractérisé en ce que** le même récipient (17) contenant le liquide chimique (18) qui a été utilisé pour graver les échantillons précédents (1) est utilisé pour le processus de gravure humide contrôlé (131, 132, 133) ;
dans lequel le ou les réglages sont contrôlés en ajustant les réglages actuels relatifs à une durée de vie pour le remplacement du liquide chimique (18), en l'ajustant de telle sorte qu'un remplacement au moins partiel et/ou un changement de composition du liquide chimique (18) dans le récipient (17) soit déclenché en fonction des données de mesure ; et
dans lequel :
(a) au moins l'un des un ou plusieurs réglages concerne un remplacement complet ou pratiquement complet du liquide chimique (18) dans le récipient (17) et indique une durée de vie au terme de laquelle le liquide chimique (18) dans le récipient (17) doit être remplacé ;
(b) au moins l'un des un ou plusieurs réglages concerne un remplacement partiel du liquide chimique (18) dans le récipient (17), indiquant une quantité et une substance du liquide chimique (18) à remplacer dans le récipient (17) ; et/ou
(c) au moins l'un des un ou plusieurs réglages concerne une modification de la composition du liquide chimique (18), indiquant un ou plusieurs agents de gravure chimiques, d'autres substances chimiques et/ou des agents de gravure supplémentaires à ajouter au liquide chimique afin de modifier la composition de ce dernier pour enrichir ou tamponner le liquide chimique (18) dans le récipient (17).

2. Procédé (200) selon la revendication 1, dans lequel les échantillons (1) sont des plaquettes (1).

3. Procédé (200) selon la revendication 1 ou 2, dans lequel le processus de gravure humide (131, 132, 133) est un processus de gravure d'échantillon unique, dans lequel des échantillons uniques (1) sont gravés consécutivement par distribution du liquide chimique (18) sur une surface d'échantillon de l'échantillon (1).

4. Procédé (200) selon l'une quelconque des revendications précédentes, dans lequel au moins l'un des un ou plusieurs réglages concerne une modification de la durée de gravure.

5. Procédé (200) selon l'une quelconque des revendications précédentes, dans lequel au moins l'un des un ou plusieurs réglages concerne une modification de la répartition du liquide chimique sur l'échantillon (1).

6. Procédé (200) selon l'une quelconque des revendications précédentes, dans lequel le procédé (200) comprend :
- l'obtention de deuxièmes données de mesure indicatives d'une composition du liquide chimique (18),
les données de contrôle étant en outre basées sur les deuxièmes données de mesure.

7. Procédé (200) selon l'une quelconque des revendications précédentes, dans lequel les données de contrôle sont en outre basées sur des données de seuil, les données de seuil indiquant un seuil pour l'enlèvement de matière, l'épaisseur et/ou la rugosité de surface des échantillons (1).

8. Procédé (200) selon l'une quelconque des revendications précédentes, dans lequel les données de contrôle sont obtenues au moins partiellement en tant que résultat d'un algorithme d'apprentissage automatique, l'algorithme d'apprentissage automatique étant entraîné au moins avec les données de mesure et/ou les données de contrôle issues de processus de gravure humide antérieurs (131, 132, 133).

9. Procédé (200) selon l'une quelconque des revendications précédentes, dans lequel le procédé (200) est configuré pour contrôler deux ou plusieurs processus de gravure humide (131, 132, 133), le procédé (200) comprenant :
- l'obtention de données de mesure indicatives d'un enlèvement de matière, d'une épaisseur et/ou d'une rugosité de surface du ou des échantillons (1) gravés après chacun des deux ou plusieurs processus de gravure humide (131, 132, 133) ; et
- l'obtention de données de contrôle destinées à contrôler un ou plusieurs réglages de chacun des deux ou plusieurs processus de gravure humide (131, 132, 133) sur la base des données de mesure.

10. Produit-programme d'ordinateur (22, 23) qui, lorsqu'il est exécuté par un dispositif de traitement de données (21), ordonne au dispositif de traitement de données (21) de mettre en œuvre le procédé (200) selon l'une quelconque des revendications précédentes.

11. Système de traitement de données (20) configuré pour mettre en œuvre le procédé (100) selon l'une quelconque des revendications 1 à 9.

12. Système (10) destiné à mettre en œuvre un processus de gravure humide (131, 132, 133), le système (10) comprenant le système de traitement de données (20) selon la revendication 11, un récipient (17) destiné à contenir le liquide chimique (18), un système de mesure (30) destiné à obtenir les données de mesure, et un distributeur (19) relié de manière fluidique au récipient (17) pour distribuer le liquide chimique (18) sur une surface d'échantillon du ou des échantillons (1) à partir du récipient (18).
